Europäisches Patentamt

European Patent Office

Office européen des brevets

(19)

(11) Publication number: **0 216 157 B1**

(12) # EUROPEAN PATENT SPECIFICATION

(45) Date of publication of the patent specification:
24.10.90

(51) Int. Cl.⁵: **H01L 21/285, H01L 21/60**

(21) Application number: 86111641.6

(22) Date of filing: 22.08.86

(54) A method of depositing metal contact regions on a silicon substrate.

(30) Priority: 27.09.85 US 780871

(43) Date of publication of application:
01.04.87 Bulletin 87/14

(45) Publication of the grant of the patent:
24.10.90 Bulletin 90/43

(84) Designated Contracting States:
DE FR GB

(56) References cited:
EP-A- 0 157 052

JAPANESE JOURNAL OF APPLIED PHYSICS.
SUPPLEMENTS, 15th CONFERENCE ON SOLID STATE
DEVICES AND MATERIALS, 30th August - 1st
September 1983, pages 225-228, Tokyo, JP; T. MORIYA
et al.: "A new encroachment-free tungsten CVD
process with superior selectivity" eous terminals made
for firm management the project carthage" 000
JOURNAL OF THE ELECTROCHEMICAL SOCIETY,
vol. 132, no. 5, May 1985, pages 1243-1250, Manchester,
New Hampshire, US; M.L. GREEN et al.: "Structure of
selective low pressure chemically vapor-deposited
films of tungsten"

(73) Proprietor: International Business Machines
Corporation, Old Orchard Road, Armonk, N.Y. 10504(US)

(72) Inventor: Iyer, Subramanian Srikanteswara, 3081 Radcliff
Drive, Yorktown Heights, NY 10598(US)
Inventor: Joshi, Rajiv Vasant, 4-1 Woods Brook Lane,
Yorktown Heights, NY 10598(US)

(74) Representative: Burt, Roger James, Dr., IBM United
Kingdom Limited Intellectual Property Department
Hursley Park, Winchester Hampshire SO21 2JN(GB)

**Description**

This invention relates to a method of depositing metal contact regions on a silicon substrate, and is particularly useful in the production of integrated circuits.

In a known technique (see, for example, US-A-4,349,408) for deposition of tungsten contact metal in a contact hole for subsequent planarising, a substitution reaction is used where W from $WF_6$ gas substitutes for Si in exposed silicon areas to produce a thin W surface. Hydrogen is then introduced into the CVD reactor and tungsten is deposited by reaction with the $WF_6$ source gas.

More particularly, US-A-4,349,408 relates to a method of depositing a refractory metal (tungsten) on a semiconductor substrate wherein a passivation material is also deposited around the periphery of the metal.

This is accomplished by depositing an oxygen doped polycrystalline silicon layer on one surface of the semiconductor substrate and then depositing a phosphorus doped polycrystalline silicon layer on the outermost surface of the first layer. Thereafter, windows are etched in the layers to expose surface areas of the substrate where the metal is to be deposited. Afterwards, the tungsten contact is deposited on the exposed surface areas of the substrate by CVD techniques.

In accordance with a CVD technique, tungsten (W) is deposited on the surface areas by placing the substrate in a CVD reactor and heating the substrate. Tungsten hexafluoride ($WF_6$) and an inert carrier gas such as argon (Ar) or nitrogen ($N_2$) are then fed into the reactor and the tungsten hexafluoride will react with the silicon in accordance with the following:

$$2WF_6 + 3Si \rightarrow 2W \downarrow + 3SiF_4$$

The deposition of tungsten will stop after a layer of from about 50 nm to about 200 nm thick has been deposited. Inasmuch as a layer of about 400 nm thick is desired, the deposition process must be altered. In order to deposit the additional 200 nm to 350 nm of tungsten, the temperature is lowered. At this point, hydrogen ($H_2$) is added to the tungsten hexafluoride and carrier gas. The tungsten hexafluoride will react with the hydrogen to deposit the desired additional tungsten in accordance with the following:

$$WF_6 + 3H_2 \rightarrow W \downarrow + 6HF$$

The present invention seeks to provide an improved method for forming metal contact regions on a silicon substrate.

A method for depositing metal contact regions on a silicon substrate having an apertured silicon dioxide layer thereon, comprising the steps of:

(1) disposing the substrate in a deposition chamber;

(2) introducing a gaseous compound of a metal into the chamber, which compound reacts with silicon so that metal from the compound substitutes for silicon in the surface of the substrate to form a deposited metal layer in the apertures in the silicon dioxide layer;

(3) introducing hydrogen into the chamber in addition to the gaseous compound whereby the hydrogen reacts with the gaseous compound to form a further deposition of the metal, the metal being deposited during said further deposition on the surface of both the previously deposited metal layer and the silicon dioxide layer;

the method is characterised, according to the invention, by introducing into the chamber during step (3) an etching gas which when activated etches the metal and striking a plasma to activate the etching gas so that the silicon dioxide surface portions of the substrate are kept substantially free of the metal because of the etching action of the etching gas whereas a further deposit of the metal is produced on the previously deposited metal layer because the rate of deposition of the metal is higher on the metal than on silicon.

How the invention can be carried out will now be described by way of example, with reference to the accompanying drawings, in which:-

Figure 1 is a schematic cross-section of part of an integrated circuit chip showing a planarising metal stud in a contact hole;

Figure 2 represents a typical apparatus for carrying out a method embodying the present invention; and

Figure 3 is a schematic representation of a cross-section of an integrated circuit chip including tungsten contact regions deposited by a method embodying the invention.

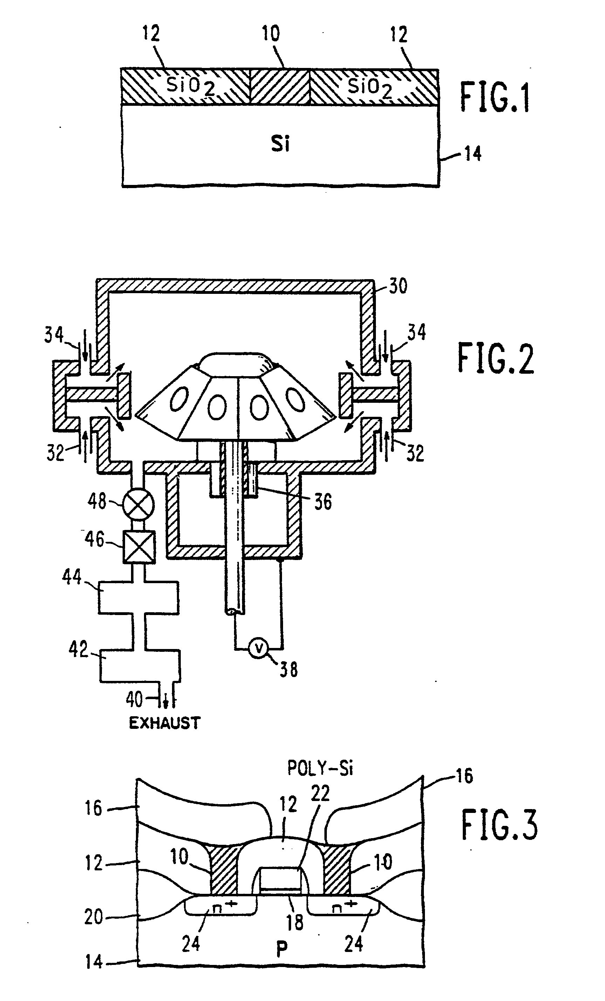

Contact as well as inter-level vias on a Very Large Scale Integrated Circuit (VLSI) chip present a serious concern from the metal coverage point of view. The severe topography results in poor step coverage and this results in problems, such as electromigration. These problems may be minimised by the use of a metal planarising stud in the via as shown in Figure 1 wherein a metal stud 10 is provided in a contact hole (via) in the insulation layer 12 on the semiconductor substrate 14.

However, selective deposition of metal in the via alone and planarising this structure is a very complex process. Selective chemical vapour deposition (CVD) of tungsten techniques have been employed.

In these techniques, use is made of a substitution reaction, where tungsten W from tungsten hexafluoride $WF_6$ source gas, substitutes for silicon Si in the exposed silicon areas.

$$2WF_6 + 3Si \rightarrow 2_W + 3SiF^4$$

This is a truly selective reaction but has the limitation that it is self-limiting. After the surface layer (perhaps a few 10 nm deep) is converted to W, no further substitution takes place. At this point, hydrogen is bled into the CVD reactor. Now tungsten is deposited by the net reaction

$$WF_6 + 3H_2 = _W + 6H^F$$

In this part of the process, W is deposited by a nucleation type of process. In such a process, unless extremely clean $SiO_2$ surfaces exist, it is impossible in the above reaction to avoid nucleation centres on the $SiO_2$ and to thus preferentially deposit W only on the W surfaces created by the initial part of the process. There are serious practical problems with this technique. It has been found that it is very difficult to maintain a clean $SiO_2$ surface and that selective deposition is not possible in a reproducible and reliable manner. Further, it has been found that selectivity is lost whenever thick films of W (> 100 nm) are to be deposited.

The present invention provides an improved technique to overcome the above difficulties. An apparatus to carry out the process is shown in schematic form in Figure 2. The deposition process chamber 30 contains the specimens. Tungsten hexafluoride gas is introduced into chamber 30 through ports 32. A hydrogen-helium combination is introduced into chamber 30 through ports 34. Excitation is provided by the rf generator 38 and an infrared sensor lamp assembly 36 is provided. A high vacuum valve 48, a throttle valve 46, a blower 44 and pump 42 are provided to exhaust chamber 30 through port 40. The initial portion of the process remains similar to the prior art steps described previously. The exposed Si surfaces on which the selective deposition is to be performed, are first converted to W surfaces by the substitution reaction:

$$2WF_6 + 3Si \rightarrow 2_W + 3SiF4$$

After the surface has been substituted, the second part of the process is initiated. This involves three parameters. First, the $Wf_6$ is mixed with $H_2$ as before to give deposition of W by partially preferential nucleation on the already converted W surfaces. Then $NF_3$ is bled into the system and a plasma is struck in the reaction chamber. The effect of the latter two actions is to create a simultaneous etching condition for the tungsten.

$$NF_3 \xrightarrow{\text{Plasma}} F + \text{other products}$$
$$F + W \longrightarrow WF_6$$

(here charge balance has been neglected).

The amount of $NF_3$ and the plasma power coupled into the chamber are such as to ensure that the $SiO_2$ surface is kept clean at all times. Thus any nuclei that may be formed on the $SiO_2$ surface, are immediately cleaned out. Since the deposition rate on the exposed W surfaces is much higher than on the $SiO_2$ surfaces, there will be net deposition on these areas in spite of the etching action. The important advantage is that selectivity is maintained even for thick W films. Also, the deposition rate in the second part of the process is actually increased due to the plasma.

The resultant contact structure is shown in the schematic illustration of Figure 3. The metal contacts 10, formed of metal studs in the via holes in the silicon dioxide layer 12 interconnect aluminium layers 16 and the n+ regions 24. The recessed oxide isolation regions 20 and the polysilicon gate 22 with its gate oxide 18 form the rest of the integrated circuit.

Thus, there has been described herein a differential deposition technique, which takes a reaction that is quasi selective and combines it with an in-situ etching process to yield a truly selective deposition process that is capable of very thick selectively deposited metal films.

Although tungsten is the preferred contact metal, other contact metals may be similarly selectively deposited by a method embodying the invention.

**Claims**

1. A method for depositing metal contact regions on a silicon substrate having an apertured silicon dioxide layer thereon, comprising the steps of:
   (1) disposing the substrate in a deposition chamber;
   (2) introducing a gaseous compound of a metal into the chamber, which compound reacts with silicon so that metal from the compound substitutes for silicon in the surface of the substrate to form a deposited metal layer in the apertures in the silicon dioxide layer; and
   (3) introducing hydrogen into the chamber in addition to the gaseous compound whereby the hydrogen reacts with the gaseous compound to form a further deposition of the metal, the metal being deposited during said further deposition on the surface of both the previously deposited metal layer and the silicon dioxide layer;

the method being characterised by introducing into the chamber during step (3) an etching gas which when activated etches the metal and striking a plasma to activate the etching gas so that the silicon dioxide surface portions of the substrate are kept substantially free of the metal because of the etching action of the etching gas whereas a further deposit of the metal is produced on the previously deposited metal layer because the rate of deposition of the metal is higher on the metal than on silicon.

2. A method as claimed in claim 1, in which the gaseous compound is tungsten hexafluoride and the deposited metal is tungsten.

3. A method as claimed in claim 1, or claim 2, in which the etching gas is nitrogen trifluoride.

**Patentansprüche**

1. Verfahren zum Auftragen von Metallkontaktzonen auf ein mit einer offenen Silikondioxidschicht versehenes Silikonsubstrat, folgende Schritte enthaltend:

(1) Anordnen des Substrats in einer Auftragskamnmer;

(2) Einführen einer gasförmigen Metallverbindung in die Kammer, wobei die Metallverbindung mit dem Silikon reagiert, so daß Metall aus der Verbindung an die Stelle des Silikons an der Oberfläche des Substrats tritt, um eine aufgetragene Metallschicht in den Öffnungen in der Silikondioxidschicht zu bilden; und

(3) Einführen von Wasserstoff in die Kammer, zusätzlich zu der gasförmigen Verbindung, wodurch der Wasserstoff mit der gasförmigen Verbindung reagiert, um eine weitere Metallablagerung zu bewirken, und das Metall in diesem weiteren Auftragsvorgang auf der Oberfläche sowohl der zuerst abgelagerten Metallschicht als auch der Silikondioxidschicht aufgetragen wird;

Verfahren dadurch gekennzeichnet, daß im Schritt (3) ein ätzendes Gas in die Kammer eingeführt wird, welches nach Aktivierung das Metall ätzt, und ein Plasma das Ätzgas aktiviert, so daß die Silikondioxid-Oberflächenteile des Substrats im wesentlichen von Metall freigehalten werden, infolge der Ätzwirkung des ätzenden Gases, während auf der vorher abgelagerten Metallschicht weiter Metall abgelagert wird, da die Metallauftragsrate auf dem Metall größer ist als auf Silikon.

2. Verfahren gemäß Abschnitt 1, in dem die gasförmige Verbindung Wolframhexafluorid und das aufgetragene Metall Wolfram ist.

3. Verfahren gemäß Abschnitt 1 oder Abschnitt 2, in dem das Ätzgas Stickstofftrifluorid ist.

**Revendications**

1. Procédé de dépôt de régions de contact métallique sur un substrat de silicium revêtu d'une couche de dioxyde de silicium munie d'ouvertures, comprenant les étapes suivantes:

(1) déposer le substrat dans une chambre de dépôt;

(2) introduire un composé gazeux d'un métal dans la chambre, ce composé réagissant avec le silicium de sorte que le métal en provenance du composé se substitue au silicium à la surface du substrat pour former une couche métallique déposée dans les ouvertures dans la couche de dioxyde de de silicium; et

(3) introduire de l'hydrogène dans la chambre en plus du composé gazeux, d'où il résulte que l'hydrogène réagit avec le composé gazeux pour former un dépôt complémentaire de métal, le métal étant déposé pendant ce dépôt complémentaire sur la surface de la couche métallique précédemment déposée et de la couche de dioxyde de silicium;

ce procédé étant caractérisé par l'introduction dans la chambre pendant l'étape (3) d'un gaz de gravure qui, quand il est activé, attaque le métal et par la formation d'un plasma pour activer le gaz de gravure de sorte que les parties superficielles de dioxyde de silicium du substrat sont maintenues sensiblement exemptes de métal en raison de l'action de gravure du gaz de gravure, tandis qu'un dépôt complémentaire du métal est produit sur la couche métallique précédemment déposée car la vitesse de dépôt du métal est plus élevée sur le métal que sur le dioxyde de silicium.

2. Procédé selon la revendication 1, dans lequel le composé gazeux est de l'hexafluorure de tungstène et le métal déposé est du tungstène.

3. Procédé selon la revendication 1 ou la revendication 2, dans lequel le gaz de gravure est du trifluorure d'azote.

FIG.1

12 10 12

SiO₂ SiO₂

Si

14

FIG.2

30

34 34

32 32

48

46

44

42

40

EXHAUST

36

38 V

POLY-Si

FIG.3

16 16

12 22

16 10 10

12

20 n⁺ n⁺

24 18 24

14 P